# EUROPÄISCHE PATENTSCHRIFT

(11) **EP 3 057 128 B1**
(45) Veröffentlichungstag und Bekanntmachung des Hinweises auf die Patenterteilung: **27.06.2018**
(21) Anmeldenummer: 16150873.4
(22) Anmeldetag: 12.01.2016
(51) Int. Cl.: H01L 23/40

(54) **ELEKTRONISCHES INSTALLATIONSGERÄT DER GEBÄUDE-INSTALLATIONSTECHNIK**
ELECTRONIC INSTALLATION DEVICE OF DEVICE INSTALLATION TECHNOLOGY
APPAREIL D'INSTALLATION ELECTRONIQUE APPARTENANT A L'IMMOTIQUE

(30) Priorität: 11.02.2015 DE 102015001588
(43) Veröffentlichungstag der Anmeldung: 17.08.2016
(73) Patentinhaber: ABB AG, 68309 Mannheim (DE)
(72) Erfinder: Mrkajic, Oliver, 58511 Lüdenscheid (DE); Bankstahl, Johannes, 58739 Wickede / Ruhr (DE); Ewers, Manfred, 58239 Schwerte (DE); Clever, Gerhard, 58553 Halver (DE); Czimmeck, Frank, 58511 Lüdenscheid (DE); Denke, Frank, 58509 Lüdenscheid (DE); Kümmerling, Mike, 58579 Schalksmühle (DE); Selzer, Uwe, 58511 Lüdenscheid (DE); Klein, Gregor, 58509 Lüdenscheid (DE)

(56) Entgegenhaltungen:
- EP-A2- 2 793 337
- WO-A1-92/17904
- DE-U1- 9 014 091
- US-A- 5 784 254
- US-A1- 2011 013 374

## Beschreibung

Die Erfindung betrifft ein elektronisches Installationsgerät der Gebäudeinstallationstechnik gemäß den Merkmalen des Patentanspruches 1. Das erfindungsgemäße Installationsgerät kann als Unterputz- oder Aufputz- Gerät ausgeführt sein.

In elektronischen Hausinstallationsgeräten (z.B. Dimmer, Drehzahlsteller, Netzteile) werden häufig Kühlkörper zur Wärmeableitung von wärmentwickelnden Bauteilen, beispielsweise bei Spulen, Spannungswandlern oder Leistungshalbleitern verwendet. Die Kühlkörper müssen für eine effiziente Wirkung zwingend an der Wärmequelle des wärmentwickelnden Bauteiles anliegen. Dabei sollte idealerweise zwischen Kühlkörper und wärmentwickelndem Bauteil ein Kontaktdruck herrschen, so dass die Wärme über die gesamte Produktlebensdauer effizient abgeleitet werden kann. Dazu werden die Kühlkörper oftmals mit der Wärmequelle verschraubt, um einen konstanten Anpressdruck zu erreichen.

Die Montage der Kühlkörper mittels der Schraubverbindung bedingt eine Vielzahl von Arbeitsschritten, wie Schraube fügen, Mutter positionieren und Mutter mittels definiertem Drehmoment mit Schraube verbinden.

Alternativ zu verschraubten Kühlkörpern ist in der DE 10 2013 006 728 A1 eine Klemmblech beschrieben, an welches eine Klemmvorrichtung derart angeformt ist, dass das Kühlblech ohne weitere Fügebauteile, wie beispielsweise Schrauben, an das wärmeableitende Bauteil angepresst wird. Da das Kühlblech und die daran befindliche Klemmvorrichtung zur Verbindung mit dem wärmentwickelnden Bauteil üblicherweise einen Kupferanteil aufweist, der zusätzlich zur Temperaturbelastung durch die vom Bauteil abgegebene Wärme, eine Verringerung der Anpresskräfte zwischen Kühlkörper und dem wärmentwickelnden Bauteil bedingt, verschlechtert sich die Wärmeableitung vom wärmentwickelnden Bauteil über einen längeren Zeitraum.

Der Erfindung liegt die Aufgabe zugrunde, ein elektronisches Installationsgerät der Gebäudeinstallationstechnik mit optimierter Kühlung von wärmeentwickelnden Bauteilen anzugeben, dessen Montage in einfacher Weise ausführbar ist.

Diese Aufgabe wird erfindungsgemäß gelöst durch ein elektronisches Installationsgerät der Gebäudeinstallationstechnik nach Anspruch 1 mit einem Gerätesockel- oder Schalteinsatz, wobei im Inneren des Gehäuses des Gerätesockel- oder Schalteinsatzes mindestens ein wärmeentwickelndes Bauteil und wenigstens ein Kühlkörper zur Abfuhr der Verlustwärme vom Gehäuseinneren zum Äußeren des Gehäuses vorgesehen ist.

Erfindungsgemäß ist der Kühlkörper durch wenigstens eine Klemmfeder mit dem wärmentwickelnden Bauteil verbunden, wobei die Klemmfeder den Kühlkörper sowie das wärmentwickelnde Bauteil umgreift. Dabei wird ein konstanter Anpressdruck des Kühlkörpers an das wärmeentwickelnde Bauteil erreicht.

Die mit der Erfindung erzielbaren Vorteile liegen insbesondere darin, dass der Kühlkörper durch die Klemmfeder an die Wärmequelle gedrückt wird, wodurch eine ausreichende Abgabe von Verlustwärme des wärmentwickelnden Bauteiles zuverlässig gewährleistet ist.

Durch die Geometrie und spezifische Materialwahl der verwendeten Klemmfeder wird der Kontaktdruck auch über die Produktlebensdauer, selbst bei der hohen Wärmeentwicklung, konstant gehalten. Zusätzliche Verbindungselemente, wie Schrauben, Muttern und Unterlegscheiben zur Befestigung des Kühlkörpers an den wärmeentwickelnden Bauteilen und entsprechende Montageschritte zum Anschrauben des Kühlbleches an das wärmeentwickelnde Bauteil entfallen, wodurch die Montage vereinfacht wird.

Dadurch, dass zur Verbindung des Kühlbleches mit dem wärmeentwickelnden Bauteil kein Verbindungselement verwendet wird, dass mit dem Kühlkörper ein gemeinsames Teil bildet, ergeben sich die folgenden weiteren Vorteile.

Der Kühlkörper ist einfach und kostengünstig, im besten Fall werkzeuglos, herstellbar. Für die Herstellung des Kühlkörpers mit daran befindlicher Klemmvorrichtung, wie dies beispielsweise in der DE 10 2013 006 728 A1 beschrieben ist, muss dagegen ein teures Folgeverbundwerkzeug verwendet werden. Dies ist durch die verwendete Klemmfederanordnung gemäß der vorliegenden Erfindung nicht erforderlich.

Anhand der in den folgenden Zeichnungen dargestellten Ausführungsbeispiele sollen die Erfindung, weitere Ausführungsformen und Vorteile näher beschrieben werden.

Es zeigen:
- **Fig.** 1: zwei beispielhafte Ausführungsformen einer Klemmfeder, vorgesehen zur Verbindung eines Kühlkörpers mit einem wärmentwickelnden Bauteil,
- **Fig.** 2: eine beispielhafte Ausführungsform eines Kühlkörpers,
- **Fig.** 3: eine beispielhafte Leiterplatten-Baugruppe mit zwei wärmeentwickelnden Bauteilen, die in einen Gerätesockel- oder Schalteinsatz eines Installationsgerätes einsetzbar sind,
- **Fig.** 4: eine beispielhafte Leiterplatten-Baugruppe mit zwei wärmeentwickelnden Bauteilen und einem Kühlblech nach der Montage des Kühlbleches mit einer Klemmfeder nach Fig. 1a, und
- **Fig.** 5: eine weitere beispielhafte Leiterplatten-Baugruppe mit zwei wärmeentwickelnden Bauteilen nach der Montage des Kühlbleches mit einer Klemmfeder nach Fig. 1b.

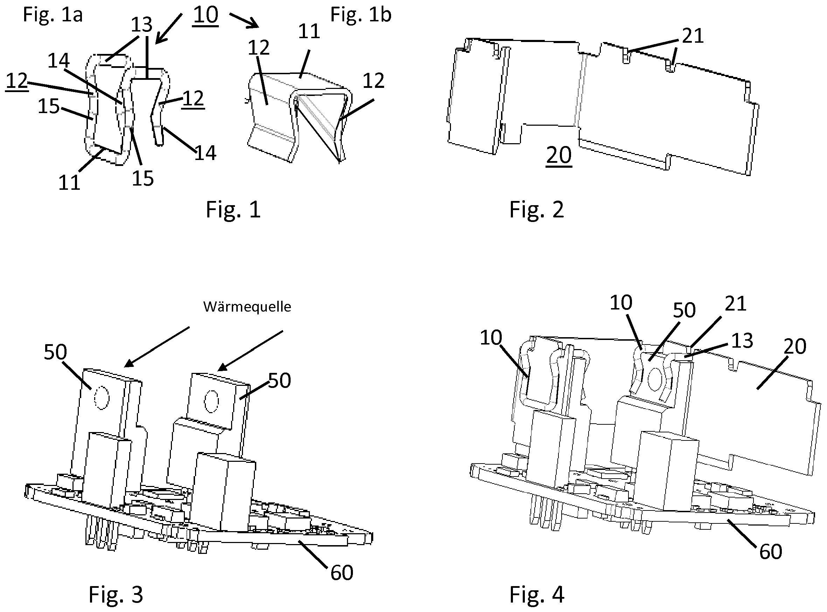

In der **Fig.** 1 sind zwei beispielhafte Ausführungsformen einer Klemmfeder 10 gezeigt. Die aus federnden Material bestehende Klemmfeder 10 ist zur Verbindung eines auf einer im Inneren eines Gehäuses eines Gerätesockel- oder Schalteinsatzes eines elektronischen Unterputz- Installationsgerätes befindlichen Leiterplatten- Baugruppe angeordneten wärmentwickelnden Bauteils mit einem Kühlkörper vorgesehen.

Die Klemmfeder 10 kann in einer bevorzugten Ausführungsform ein gebogener Metalldraht oder Federdraht sein.

Die Klemmfeder 10 weist in der hier gezeigten beispielhaften Ausführungsform einen ersten Steg 11 auf, an dessen Enden jeweils ein Federteil bzw. ein Federbügel 12 angeordnet ist. Die Klemmfeder 10 umgreift den Kühlkörper und das wärmeentwickelnde Bauteil und sorgt dafür, dass zwischen Kühlkörper und wärmeabgebendem Bauteil ein ausreichend hoher Anpressdruck entsteht.

In der ersten Ausführungsform gemäß Fig. 1a ist die Klemmfeder als Drahtfeder ausgeführt. Jedes Federteil 12 ist aus zwei über einen zweiten Steg 13 miteinander verbundenen Federschenkeln, einem äußeren ein freies Ende aufweisenden Federschenkel 14 und über den zweiten Steg 13 damit verbundenem innenliegenden Federschenkel 15 gebildet, wobei der innenliegende Federschenkel 15 mit dem ersten Steg 11 verbunden ist.

In der zweiten Ausführungsform gemäß Fig. 1b ist die Klemmfeder 10 als eine aus einem Blechteil gefertigte Federklammer ausgeführt, die bevorzugt aus zwei einstückigen Federteilen 12 aufgebaut ist. Die Federteile 12 können an ihren freien Enden nach außen abgewinkelt sein, um dass Fügen der Klemmfeder 10 mit dem Bauteil 50 zu erleichtern.

**Fig.** 2 zeigt eine beispielhafte Ausführungsform des in das Gehäuse des Schalteinsatzes einzubringenden separaten Kühlkörpers 20, welcher beispielsweise als abgewinkeltes Kühlblech ausgeführt ist und zur Abfuhr der Verlustwärme vom Gehäuseinneren des Gerätesockel- oder Schalteinsatzes vorgesehen ist. Das Kühlblech bildet dabei nach seiner Montage auf der Leiterplatten- Baugruppe des Installationsgerätes bis zu drei Hauptflächen parallel zu den Gehäuseflächen des Gerätesockel- oder Schalteinsatzes.

In vorteilhafter Weise können im Kühlblech 20 Ausnehmungen 21 vorgesehen, in welche der Steg 13 der Klemmfeder 10 gemäß Ausführungsform nach Fig. 1a (siehe Fig. 4) oder der Steg 11 der Klemmfeder 10 gemäß Ausführungsform nach Fig. eingreift.

**Fig.** 3 zeigt eine beispielhafte Leiterplatten-Baugruppe 60 mit zwei darauf angeordneten wärmeentwickelnden Bauteilen 50, weiteren elektronischen Bauteilen vor der Montage des Kühlbleches 20. Die Leiterplatten- Baugruppe 60 ist in einen Gerätesockel- oder Schalteinsatz eines Installationsgerätes, beispielsweise eines Dimmers, einsetzbar.

In der **Fig.** 4 ist die Leiterplatten-Baugruppe 60 mit den beiden wärmeentwickelnden Bauteilen 50, beispielsweise Leistungshalbleitern, und dem Kühlblech 20 nach dessen Montage, dargestellt, wobei die Klemmfedern 10 gemäß Fig. 1a mit ihrem zweiten Steg 13 in die Ausnehmungen 21 des Kühlbleches 20 eingreifen.

Die Montage der Klemmverbindung zwischen dem Kühlkörper 20 und dem wärmeentwickelndem Bauteil 50 beschränkt sich dabei nur noch auf die folgenden Arbeitsschritte:
1. Klemmfeder 10 positionieren
2. Klemmfeder 10 fügen und durch den dabei entstehenden konstanten Anpressdruck des Kühlkörpers an das wärmeentwickelnde Bauteil eine wärmeleitende Verbindung zwischen dem Kühlkörper 20 und dem wärmeentwickelndem Bauteil 50 erzeugen.

Mittels der vorgeschlagenen Klemmverbindung sind am Kühlkörper keine zusätzlichen Geometrien, beispielsweise angeformte Federlaschen, zur Befestigung des Kühlbleches 20 an den wärmeabgebenden Bauteilen 50, mehr erforderlich.

Die aus Klemmfeder 10, Kühlkörper 20 und Wärmequelle 50 bestehende Anordnung kann universell verwendet werden und hat somit keine Abhängigkeiten zu externen Geometrien von Kühlkörper 20 und wärmeentwickelndem Bauteil 50.

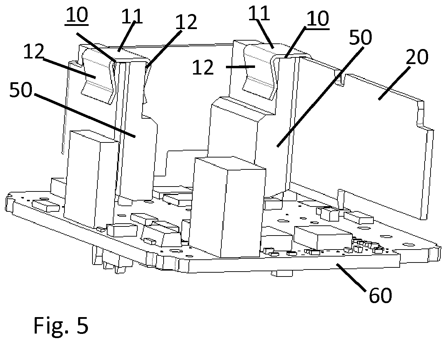

In der **Fig.** 5 ist eine weitere beispielhafte Leiterplatten-Baugruppe 60 mit zwei wärmeentwickelnden Bauteilen 50 nach der Montage des Kühlbleches 20 mittels der in der Fig. gezeigten Ausführungsform der Federklammer 10 als Einheit dargestellt.

Die Leiterplatten-Baugruppe 60 ist in das Innere des Gehäuses des Gerätesockel- oder Schalteinsatzes einsetzbar.

Die beiden einstückigen Federteile 12 und der Steg 11 der Klemmfeder 10 bilden dabei eine lösbare Verbindung mit einem konstanten Anpressdruck zwischen dem Kühlkörper 20 und dem wärmeentwickelndem Bauteil 50.

### Bezugszeichenliste

- 10: Klemmfeder
- 1a: Klemmfeder in Ausführung als Drahtfeder
- 1b: Klemmfeder in Ausführung als Blechteil
- 11: erster Steg
- 12: Federteil, Federbügel
- 13: zweiter Steg
- 14: äußerer Federschenkel
- 15: innenliegender Federschenkel
- 20: Kühlkörper, Kühlblech
- 21: Ausnehmung
- 40: elektrische Steckverbindung zum Unterputzeinsatz
- 50: wärmeentwickelndes Bauteil
- 60: Leiterplatten -Baugruppe

## Patentansprüche

1. Elektronisches Installationsgerät der Gebäudeinstallationstechnik mit einem Gerätesockel- oder Schalteinsatz, wobei im Inneren des Gehäuses des Gerätesockel- oder Schalteinsatzes mindestens ein wärmeentwickelndes Bauteil (50) und wenigstens ein Kühlkörper (20) zur Abfuhr der Verlustwärme vom Gehäuseinneren zum Äußeren des Gehäuses vorgesehen ist, der Kühlkörper (20) durch wenigstens eine Klemmfeder (10) mit dem wärmentwickelnden Bauteil (50) verbunden ist, um einen konstanten Anpressdruck des Kühlkörpers (20) an das wärmeentwickelnde Bauteil (50) zu erreichen,
**dadurch gekennzeichnet, dass** die Klemmfeder (10) als Drahtfeder ausgeführt ist und den Kühlkörper (20) und das wärmeentwickelnde Bauteil (50) umgreift und dafür sorgt, dass zwischen dem Kühlkörper (20) und dem wärmeentwickelnden Bauteil (50) ein ausreichend hoher Anpressdruck entsteht.

2. Elektronisches Installationsgerät nach Anspruch 1, **dadurch gekennzeichnet, dass** die Klemmfeder (10) einen ersten Steg (11) aufweist, an dessen Enden jeweils ein Federteil (12) angeordnet ist.

3. Elektronisches Installationsgerät nach Anspruch 1 oder 2, **dadurch gekennzeichnet, dass** jedes Federteil (12) aus einem äußeren ein freies Ende aufweisenden Federschenkel (14) und über einen zweiten Steg (13) damit verbundenem innenliegenden Federschenkel (15) gebildet ist, der mit dem ersten Steg (11) verbunden ist.

4. Elektronisches Installationsgerät nach Anspruch 1 oder 2, **dadurch gekennzeichnet, dass** die Klemmfeder (10) aus zwei einstückigen Federteilen (12) aufgebaut ist und die Federteile (12) an ihren freien Enden nach außen abgewinkelt sind.

## Claims

1. Electronic installation device for building installation engineering, comprising a device base insert or switching insert, wherein at least one heat-developing component (50) and at least one heat sink (20) for dissipating the heat loss from the housing interior to the exterior of the housing are provided in the interior of the housing of the device base insert or switching insert, the heat sink (20) being connected to the heat-developing component (50) by at least one clamping spring (10) in order to achieve a constant contact pressure of the heat sink (20) against the heat-developing component (50),
**characterized in that** the clamping spring (10) is embodied as a wire spring and engages around the heat sink (20) and the heat-developing component (50) and ensures that a sufficiently high contact pressure is created between the heat sink (20) and the heat-developing component (50).

2. Electronic installation device according to Claim 1, **characterized in that** the clamping spring (10) has a first web (11) which has a spring part (12) arranged at each of its ends.

3. Electronic installation device according to Claim 1 or 2, **characterized in that** each spring part (12) is formed from an outer spring limb (14), which has a free end, and an inner spring limb (15), which is connected to the said outer spring limb by means of a second web (13) and is connected to the first web (11).

4. Electronic installation device according to Claim 1 or 2, **characterized in that** the clamping spring (10) is constructed from two integral spring parts (12), and the spring parts (12) are angled outwards at their free ends.

## Revendications

1. Dispositif d'installation électronique pour la technologie d'installation dans les bâtiments, comportant une prise pour appareil ou un insert de commutateur, dans lequel au moins un composant générateur de chaleur (50) et au moins un dissipateur thermique (20) sont prévus à l'intérieur du boîtier de la prise pour appareil ou de l'insert de commutateur afin de dissiper la perte de chaleur de l'intérieur du boîtier vers l'extérieur du boîtier, et le dissipateur thermique (20) est relié au composant générateur de chaleur (50) par au moins un ressort de serrage (10), afin d'obtenir une pression de contact constante du dissipateur thermique (20) sur le composant générateur de chaleur (50),
**caractérisé en ce que** le ressort de serrage (10) est réalisé sous la forme d'un ressort en fil et s'engage autour du dissipateur thermique (20) et du composant générateur de chaleur (50) et fait en sorte qu'une pression de contact suffisamment élevée soit produite entre le dissipateur thermique (20) et le composant générateur de chaleur (50).

2. Appareil d'installation électronique selon la revendication 1, **caractérisé en ce que** le ressort de serrage (10) présente une première bande (11) aux extrémités de laquelle est respectivement disposée une partie de ressort (12).

3. Appareil d'installation électronique selon la revendication 1 ou 2, **caractérisé en ce que** chaque partie de ressort (12) est formée d'une jambe de ressort extérieure (14) ayant une extrémité libre et d'une jambe de ressort intérieure (15) reliée à celle-ci par une seconde bande (13) et reliée à la première bande (11).

4. Appareil d'installation électronique selon la revendication 1 ou 2, **caractérisé en ce que** le ressort de serrage (10) est constitué de deux parties de ressort en une seule pièce (12) et **en ce que** les parties de ressort (12) sont coudées vers l'extérieur à leurs extrémités libres.
